# EUROPEAN PATENT APPLICATION

(11) **EP 1 659 347 A2**
(43) Date of publication of application: **24.05.2006**
(21) Application number: 05257103.1
(22) Date of filing: 17.11.2005
(51) Int. Cl.: F24J 2/06, H01L 33/00

(54) **Building element including solar energy converter**

(30) Priority: 19.11.2004 US 994979
(71) Applicant: General Electronic Company, Schenectady, NY 12345 (US)
(72) Inventor: Krokoszinski, Hans-Joachim Gunter Wilhelm, 95748 Garching (DE); Stromberger, Joerg Hermann, 91186 Buechenbach (DE); Mayer, Oliver Gerhard, 81373 Muenchen (DE)
(74) Representative: Goode, Ian Roy

(57) **Abstract**

A building element (14) such as a roof tile, window pane, or building fagade element includes a fluorescence collector (16) comprising a substrate (10) and particles (30) dispersed in the substrate to absorb light (12) from a plurality of directions and radiate the absorbed light. The fluorescence collector has opposing surfaces (18, 20) and a connecting surface (24) between the opposing surfaces. A solar energy converter (32) is configured for receiving radiated light from the fluorescence collector.

## Description

The invention relates generally to building elements such as roof tiles, window panes, and building facades and more specifically to building elements having solar energy converters included therein.

Solar energy converters, such as photovoltaic or thermal converters, typically have high material cost, high installation cost and thus a high cost of energy (cost per kWh). One approach to reduce the material cost is to concentrate solar irradiation (focus light) onto an energy converter by means complex optical surface structuring, such as by a Fresnel lens. Such approaches are difficult to implement and have had difficulty in penetrating the renewable energy market.

Briefly, in accordance with one embodiment of the present invention, a building element comprises a fluorescence collector comprising a substrate and particles dispersed in the substrate to absorb light from a plurality of directions and radiate the absorbed light. The fluorescence collector has opposing surfaces and a connecting surface between the opposing surfaces. The combination of the substrate and the particles is sufficiently transparent to permit light to reach the particles for absorption and to permit particles to radiate. At least two different portions of the fluorescence collector have different absorption spectrums. The building element further comprises a solar energy converter configured for receiving radiated light from the fluorescence collector of the building element.

In accordance with another embodiment of the present invention, a roof tile comprises a fluorescence collector comprising a substrate and particles dispersed therein to absorb light from a plurality of directions and radiate the absorbed light. The fluorescence collector has opposing surfaces and a connecting surface between the opposing surfaces, and the particles comprise a dye, quantum dots, or combinations thereof. The roof tile further comprises a solar energy converter configured for receiving radiated light from the fluorescence collector of the roof tile.

In accordance with another embodiment of the present invention, a window pane comprises a fluorescence collector comprising a substrate and particles dispersed therein to absorb light from a plurality of directions and radiate the absorbed light. The fluorescence collector has opposing surfaces and at least one connecting surface between the opposing surfaces, and the particles comprise a dye, quantum dots, or combinations thereof. The window pain further comprises a solar energy converter configured for receiving radiated light from the fluorescence collector of the window pane.

These and other features, aspects, and advantages of the present invention will become better understood when the following detailed description is read with reference to the accompanying drawings in which like characters represent like parts throughout the drawings, wherein:
FIG. 1 is a perspective view of light contacting a substrate from various directions.
FIG. 2 is a perspective view of a building element in accordance with one embodiment of the present invention.
FIG. 3 is a top view of a building element in accordance with various embodiments of the present invention.
FIG. 4 is a sectional side view of a particle in a building element in accordance with the embodiment of FIG. 2.
FIG. 5 is a sectional side view of a building element substrate configuration in accordance with another embodiment of the present invention.
FIG. 6 is a sectional side view of a building element particle configuration in accordance with another embodiment of the present invention.
FIG. 7 is a perspective view of a building element shape in accordance with another embodiment of the present invention.
FIG. 8 is a sectional side view of an overlapping building element layout in accordance with another embodiment of the present invention.

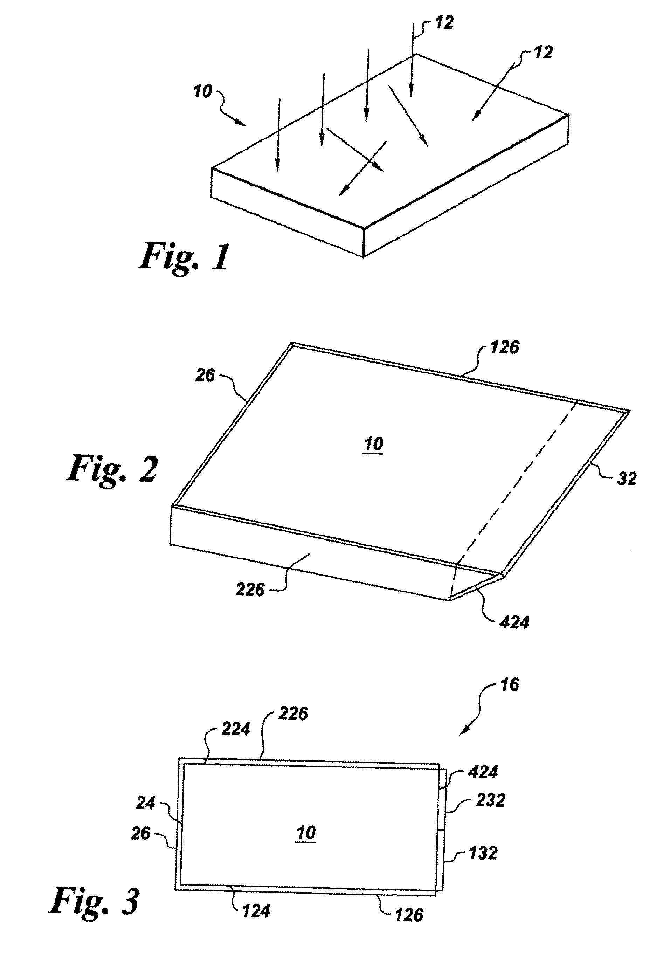

FIG. 1 is a perspective view of light 12 contacting a substrate 10 from various directions (diffuse and/or direct).

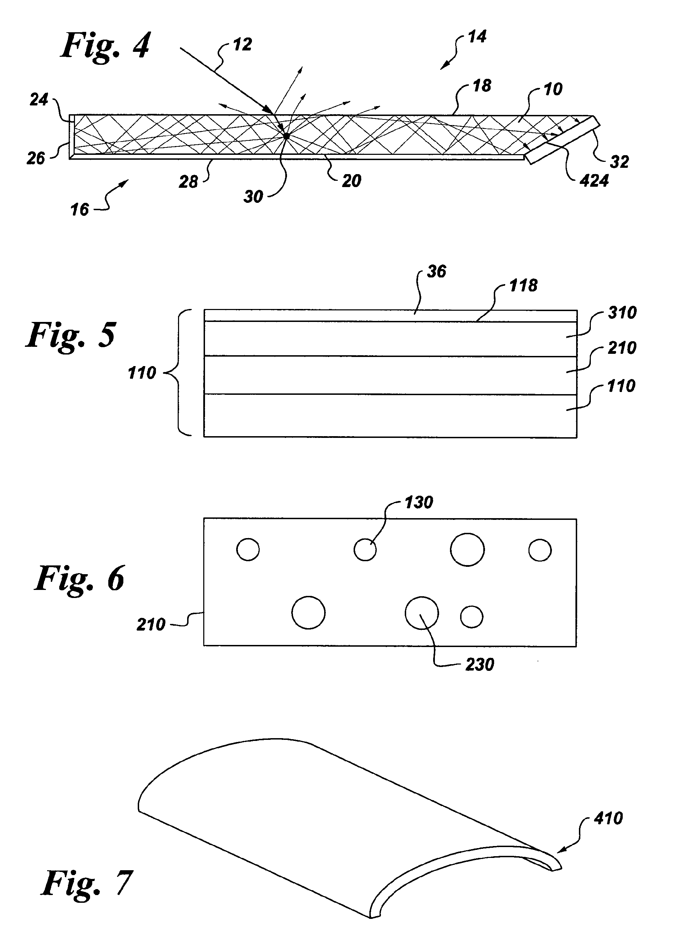

FIG. 2 is a perspective view of a building element in accordance with one embodiment of the present invention. FIG. 3 is a top view of a building element in accordance with the embodiment of FIG. 2 or various other embodiments of the present invention, and FIG. 4 is a sectional side view of a particle in a building element (including one possible alternative for the converter mounting) in accordance with the embodiment of FIG. 2.

In one embodiment of the present invention, a building element 14 (FIG. 4) comprises a fluorescence collector 16. Fluorescence collector 16 includes a substrate 10 and particles 30 dispersed in substrate 10 to absorb light 12 from a plurality of directions. The absorbed light typically is emitted with a Stockes shift (a shift towards higher wavelengths). Fluorescence collector 16 has opposing surfaces 18 and 20 and a connecting surface (meaning at least one connecting surface with one example being an edge 24) between the opposing surfaces. As used herein "opposing surfaces" means surfaces generally facing each other, and such surfaces may be parallel but need not be. The combination of substrate 10 and particles 30 is sufficiently transparent to permit light to reach particles 30 for absorption and to permit absorbed light to radiate from particles 30 to at least one surface. An optional mirrored surface (such as a coating) 26 is typically on at least one portion of a connecting surface, and a solar energy converter 32 (meaning at least one converter, such as a photovoltaic or thermal converter, for example) is mounted to receive radiated light from unmirrored portion (meaning at least one) of the fluorescence collector of the building element. In a more specific aspect, at least two different portions of fluorescence collector 16 have different absorption spectrums. In other more specific aspects, the building element 14 comprises a roof tile, a window pane, or a building façade element.

Substrate 10 may comprise any shape (geometric volume) and any material which can be formed without destroying the selected particles 30. In one example, substrate 10 comprises a plastic. In a more specific example, substrate 10 comprises a polycarbonate such as LEXAN® polycarbonate available from the General Electric Company. Other potential materials include materials such as low fabrication temperature glasses and ceramics, for example. Other non-limiting examples include polymethylmethacrylate and polystyrol as well as combinations of any of the aforementioned examples. As described in more details below, the substrate materials, the particle materials, or combinations of substrate and particle materials can be optimized to contribute to a preselected light absorption characteristic, appearance of color, shadowing, or combinations thereof. Example embodiments of different portions of the fluorescence collector having different absorption spectrums are also provided below.

Typically substrate 10 includes a plurality of connecting surfaces (such as edges 24, 124, 224, 424), but the present invention is also applicable to round or curved perimeter substrates with one continuous connecting surface. When mirrored surfaces are included on connecting or opposing surfaces, such mirrored surfaces are typically formed by applying a silver coating that is strong enough to withstand rain and other environmental factors. However, "mirrored surface" is intended to encompass any surface with properties that enable reflection. Efficiency is improved in embodiments wherein bottom opposing surface 20 comprises a mirrored surface 28 (FIG. 4). As used herein, "bottom" is not intended to be limited to a particular physical orientation but is intended to refer to the opposing surface designed to be situated farthest from the source of radiation. Such embodiments are more practical for roof tiles and building façade elements than for window panes (where more light transmission is desirable).

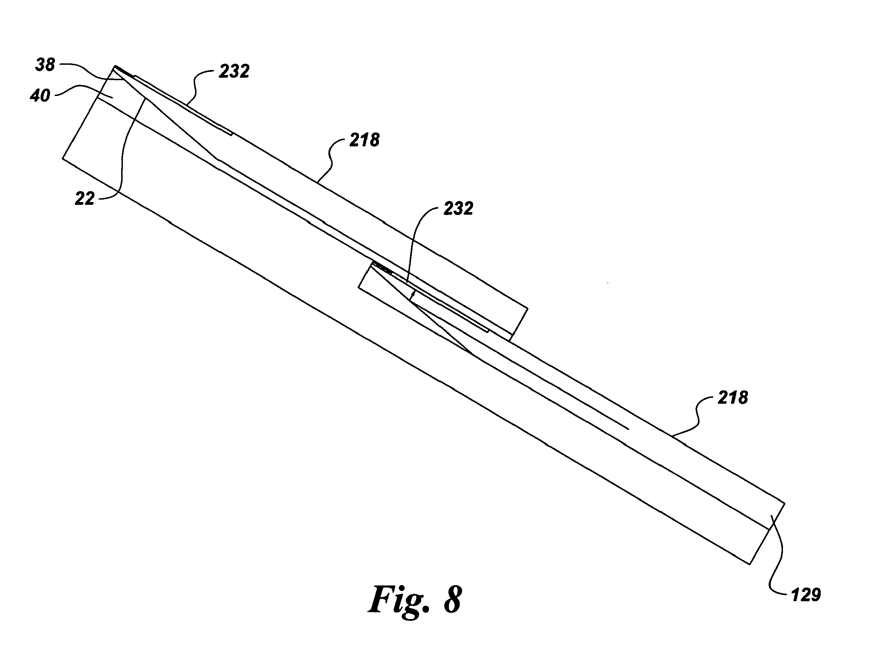

As stated above, solar energy converter 32 is mounted at an unmirrored portion of the fluorescence collector of the building element. Typically the converter will be mounted on the unmirrored connecting surface 424 itself, but not necessarily as can be seen by FIG. 8 and the accompanying description below. An adhesive (not shown) can be used to attach the converter to the substrate. Such an adhesive is selected so as to not substantially interfere with the optical properties of the substrate and the converter. Example materials include materials such as epoxies, gels, liquids, two sided tapes, and chemical/solvent combinations.

The embodiments of FIGs. 2 and 4 illustrate solar energy converter 32 as being positioned on an angled connecting surface 424. Such an angle is not necessary but can provide more surface area for solar energy converter cell mounting, if desired. Additionally, if desired, multiple converters 123 and 232 (FIG. 3) can be situated on a single connecting surface or on multiple connecting surfaces (in embodiments where light is not being directed to a single region).

In fluorescence collector 14, particles 30 absorb sun light (radiation energy) from a plurality of directions and emit the absorbed light with a defined spatial characteristic (such as, for example spherical or cone-shaped). Due to emission in various or all directions and the effect of total reflection on the collector surfaces, light is concentrated towards the connecting surfaces of the substrate. This effect is known as light pipe / edge glow effect. For example, in a four connecting surface embodiment with three of the surfaces comprising mirrored surfaces, about 15-60% of the total radiation power will reach the fourth connecting surface covered with one or more converters. For a photovoltaic (PV) cell as converter, the proposed module converts about one quarter of the irradiated power, and such cells require only a small fraction of the irradiated surface area (about 1/30). The net effect is a concentration of the light to multiples of the natural irradiation. Thus, the PV cell area needed per Watt produced power is reduced according to the "number of suns" leading to a substantial reduction of material cost and hence results in a corresponding reduction of total system cost with estimated savings of Cost of Energy of about 20-40%.

FIG. 5 is a sectional side view of a building element substrate configuration in accordance with another embodiment of the present invention. FIG. 5 illustrates a spectral selective coating 36 over one of the two opposing surfaces 118. A spectral coating is useful for filtering any undesired light, for better irradiance adaptation (e.g., hot mirror), or combinations thereof. For example, in embodiments wherein substrate 110 comprises a polycarbonate, it is useful to filter ultraviolet light rays. Coatings can also be useful for protecting the underlying substrate from rain and other environmental effects.

As stated above, in one embodiment the substrate contributes to a preselected light absorption characteristic of the building element, a preselected appearance of color of the building element, or combinations thereof. In an additional or alternative aspect to this embodiment, substrate 110 comprises a plurality of layers 110, 210, 310 with at least one of the layers having a different absorption spectrum than at least one other of the layers. A benefit to this aspect is that the layers may be optimized separately as to cover the absorption and emission in different wavelength intervals of the solar spectrum.

FIG. 6 is a sectional side view of a building element particle configuration in accordance with another embodiment of the present invention. Typically the particles comprise a dye, quantum dots, or combinations thereof. Most dyes are transparent to all wavelengths except the ones they absorb. Emission is usually in a different wavelength than absorption (Stokes shift). Typically organic molecules can withstand temperatures up to about 500 °C. A quantum dot is typically an inorganic material which becomes excited and emits light. Quantum dots advantageously have narrower bandwidth of absorption and emission but are typically higher in cost as compared with dyes.

In a more specific embodiment, to provide (either alone or in combination with the multiple layer embodiment) the different absorption spectrums, the particles in substrate 210 comprise at least two types of different particles 130 and 230 with at least one type of particle having a different absorption spectrum than at least one other type of particle. In another more specific aspect, the fluorescence collector 16 has one type of fluorescence particle with a wide absorption spectrum (such as more than one hundred nanometers, for example).

In an additional or alternative aspect, the particles contribute to a preselected appearance of color of the building element, a preselected light absorption characteristic of the building element, a preselected shadowing characteristic, or combinations thereof. When the particles comprise dyes, typically fluorescent dyes themselves create the effects, but additional dye or other material can be added if desired.

In the embodiments of FIGs. 5 and 6, more layers and dyes lead to an increase in light conversion possibly resulting in an associated increases in fabrication cost and design complexity.

FIG. 7 is a perspective view of a building element substrate shape in accordance with another embodiment of the present invention. Building elements need not be flat. For example, in the embodiment of FIG. 7, the substrate comprises a profiled substrate 410 such as those commonly used on roof tiles in Europe.

FIG. 8 is a sectional side view of a roof tile layout in accordance with another embodiment of the present invention. As described above, the present invention is not limited to embodiments wherein a solar energy converter is mounted on a connecting surface. In the embodiment of FIG. 8, the converter 232 is mounted on one of the opposing surfaces 218 of the fluorescence collector. In this embodiment, an angled mirror 38 is used for directing radiated light to the solar energy converter. The angled mirror may be situated within the substrate or on an angled connecting surface 22 of the substrate, for example.

FIG. 8 additionally illustrates an embodiment wherein the building element further includes an additional substrate 40 on which the collector is situated. The optional additional substrate can be used to provide structural support or to create a desired coloring or shadowing, for example.

FIG. 8 is further useful as an illustration of a "hidden" solar energy converter. Hidden is meant to encompass a location which is chosen to facilitate being covered when the building element is positioned in its intended environment. For example, in FIG. 8, solar energy converter 232 is covered by an adjacent building element.

Additionally, although FIG. 8 illustrates two building elements with each having an integrated converter (physically mounted on the fluorescence collector), such mounting is not required. Additionally, in embodiments wherein less power is required (than would be provided by each element including light collection capabilities) but, for aesthetics, a uniform appearance is desired, some building elements may include solar energy converters while others may not.

In a specific roof tile embodiment, which is not limited to the embodiment of FIG. 8 or any of the earlier FIGs. 1-7, a roof tile 14 comprises a fluorescence collector 16 comprising a substrate 10 and particles 30 dispersed therein to absorb light 12 from a plurality of directions and radiate the absorbed light, the fluorescence collector having two opposing surfaces 18, 20 and a connecting surface 24 between the opposing surfaces, wherein the particles comprise a dye, quantum dots, or combinations thereof. Typically a mirrored surface 26 is on at least one portion of the connecting surface, and a solar energy converter 32 (meaning at least one) mounted near an unmirrored portion (meaning at least one) of the fluorescence collector of the roof tile. Such roof tiles can be attached with nails or, as is common in Europe, by hanging on a hutch and letting the weight hold them in place. Each of the examples and embodiments described above with respect to building elements generally is also applicable to the roof tile embodiment.

Thus, embodiments of the present invention can provider a roof tile element, which is tile like in shape and appearance and can thus be used to provide a normal roof tile appearance. In an even more specific embodiment, a certain number of these roof elements will replace parts of a roof and produce electrical energy without compromising the optical appearance of a tile-structured roof.

In a specific window pane embodiment, a window pane comprises a fluorescence collector 16 comprising substrate 10 and particles 30 dispersed therein to absorb light 12 from a plurality of directions and radiate the absorbed light, the fluorescence collector having two opposing surfaces 18 and 20 and a connecting surface between the opposing surfaces. Typically a mirrored surface 26 is present on at least one portion of the connecting surface, and a solar energy converter 32 (meaning at least one) mounted at an unmirrored portion (meaning at least one) of the fluorescence collector of the window pane. Each of the examples and embodiments descried above with respect to building elements generally is likewise applicable to the window pain embodiment with selective shadowing being particularly beneficial.

With regard to the building façade embodiments, such embodiments can be similar to aluminum, vinyl, or wood siding type embodiments. One example is an overhanging siding element which would resemble the building elements of FIG. 8. The lengths of such siding elements will depend upon what is physically practical and what is design optimized for optical performance to direct a useful amount of light to the solar energy converter. Light collection may be enhanced by situating a plurality of fluorescence collectors on a common substrate to be installed as a building façade, for example.

The previously described embodiments of the present invention have many advantages, including the advantage of providing a building element with integrated fluorescence-based light collection in order to conduct the radiation energy to the solar energy converter for electricity or heat production such that mounting of photovoltaic (PV) or thermal collectors on top of the existing building elements is no longer needed.

For completeness, various aspects of the invention are set out in the following numbered clauses:
1. A building element comprising:
   a fluorescence collector comprising
   a substrate, and
   particles dispersed in the substrate to absorb light from a plurality of directions and radiate the absorbed light,
   the fluorescence collector having opposing surfaces and a connecting surface between the opposing surfaces,
   wherein the combination of the substrate and the particles is sufficiently transparent to permit light to reach the particles for absorption and to permit particles to radiate,
   wherein at least two different portions of the fluorescence collector have different absorption spectrums; and
   a solar energy converter configured for receiving radiated light from the fluorescence collector of the building element.
2. The building element of clause 1 further comprising a spectral selective coating over at least one of the opposing surfaces.
3. The building element of clause 1 wherein the particles comprise a dye, quantum dots, or combinations thereof.
4. The building element of clause 3 wherein the particles comprise at least two types of different particles, with at least one type of particle having a different absorption spectrum than at least one other type of particle.
5. The building element of clause 3 wherein the particles contribute to a preselected appearance of color of the building element.
6. The building element of clause 3 wherein the particles contribute to a preselected light absorption characteristic of the building element, a preselected shadowing characteristic of the building element, or combinations thereof.
7. The building element of clause 1 wherein the substrate comprises a polycarbonate.
8. The building element of clause 1 wherein the substrate is selected from the group consisting of glass, polymethylmethacrylate, polystyrol, ceramics, and combinations thereof.
9. The building element of clause 1 wherein the substrate contributes to a preselected light absorption characteristic of the building element, a preselected appearance of color of the building element, a preselected shadowing characteristic of the building element, or combinations thereof.
10. The building element of clause 1 wherein the substrate comprises a plurality of layers, at least one of the layers having a different absorption spectrum than at least one other of the layers.
11. The building element of clause 1 wherein at least a portion of at least one of the opposing and connecting surfaces comprises a mirrored surface.
12. The building element of clause 11 wherein the connecting surface comprises a plurality of connecting surfaces.
13. The building element of clause 12 wherein an unmirrored portion of the fluorescence collector is on one connecting surface and wherein the mirrored surface is present on at least one of the other connecting surfaces.
14. The building element of clause 13 wherein one of the opposing surfaces comprises a bottom opposing surface and wherein the bottom opposing surface comprises a mirrored surface.
15. The building element of clause 12 wherein an unmirrored portion of the florescence collector is on at least one connecting surface and wherein the solar energy converter is mounted on the unmirrored portion of the at least one connecting surface.
16. The building element of clause 1 wherein the solar energy converter is mounted on one of the opposing surfaces of the fluorescence collector and further comprising an angled mirror for directing radiated light to the converter.
17. The building element of clause 16 wherein the angled mirror is situated on an angled connecting surface of the fluorescence collector.
18. The building element of clause 1 further comprising an additional substrate on which the collector sits.
19. The building element of clause 1 wherein the building element comprises a roof tile and wherein the solar energy converter comprises a hidden converter.
20. The building element of clause 19 where the substrate comprises a profiled substrate.
21. The building element of clause 1 wherein the building element comprises a window pane.
22. The building element of clause 21 wherein the particles contribute to a preselected light absorption characteristic of the building element.
23. The building element of clause 21 wherein the substrate contributes to a preselected light absorption characteristic of the building element.
24. The building element of clause 1 wherein the building element comprises a building facade element.
25. A roof tile comprising:
   a fluorescence collector comprising a substrate and particles dispersed therein to absorb light from a plurality of directions and radiate the absorbed light, the fluorescence collector having opposing surfaces and a connecting surface between the opposing surfaces wherein the particles comprise a dye, quantum dots, or combinations thereof;
   a solar energy converter configured for receiving radiated light from the fluorescence collector of the roof tile.
26. The roof tile of clause 25 wherein the solar energy converter comprises a hidden converter.
27. The roof tile of clause 25 further comprising a spectral selective coating over one of the opposing surfaces.
28. The roof tile of clause 27 wherein the particles comprise at least two types of different particles, with at least one type of particle having a different absorption spectrum than at least one other type of particle.
29. The roof tile of clause 27 wherein the particles contribute to a preselected appearance of color of the roof tile.
30. The roof tile of clause 25 wherein the plastic substrate contributes to a preselected appearance of color of the roof tile.
31. The roof tile of clause 25 wherein the plastic substrate comprises a plurality of layers, at least one of the layers having a different absorption spectrum than at least one other of the layers.
32. The roof tile of clause 25 wherein at least a portion of at least one of the opposing and connecting surfaces comprises a mirrored surface.
33. The roof tile of clause 32 wherein the connecting surface comprises a plurality of connecting surfaces.
34. The roof tile of clause 33 wherein an unmirrored portion of the fluorescence collector is on one of the connecting surfaces and wherein the mirrored surface is present on another of the connecting surfaces.
35. The roof tile of clause 34 wherein one of the opposing surfaces comprises a bottom opposing surface and wherein the bottom opposing surface comprises a mirrored surface.
36. The roof tile of clause 33 wherein an unmirrored portion of the florescence collector is on at least one connecting surface and wherein the solar energy converter is mounted on the unmirrored portion of the at least one connecting surface.
37. The roof tile of clause 25 wherein the solar energy converter is mounted on one of the opposing surfaces of the fluorescence collector and further comprising an angled mirror for directing radiated light to the converter.
38. The roof tile of clause 37 wherein the angled mirror is situated on an angled connecting surface of the fluorescence collector.
39. The roof tile of clause 25 further comprising an additional substrate on which the collector sits.
40. The roof tile of clause 25 where the substrate comprises a profiled substrate.
41. The roof tile of clause 25 wherein the substrate is selected from the group consisting of glass, polymethylmethacrylate, polystyrol, ceramics, and combinations thereof.
42. The roof tile of clause 25 wherein the substrate comprises a polycarbonate.
43. A window pane comprising:
   a fluorescence collector comprising a substrate and particles dispersed therein to absorb light from a plurality of directions and radiate the absorbed light, the fluorescence collector having opposing surfaces and at least one connecting surface between the opposing surfaces, wherein the particles comprise a dye, quantum dots, or combinations thereof;
   a solar energy converter configured for receiving radiated light from the fluorescence collector of the window pane.
44. The window pane of clause 43 wherein the particles contribute to a preselected light absorption characteristic of the window pane.
45. The window pane of clause 43 wherein the substrate contributes to a preselected light absorption characteristic of the window pane.
46. The window pane of clause 43 further comprising a spectral selective coating over one of the opposing surfaces.
47. The window pane of clause 43 wherein the particles comprise a dye, quantum dots, or combinations thereof.
48. The window pane of clause 47 wherein the particles comprise at least two types of different particles, with at least one type of particle having a different absorption spectrum than at least one other type of particle.
49. The window pane of clause 47 wherein the particles contribute to a preselected appearance of color of the window pane.
50. The window pane of clause 47 wherein the particles contribute to a preselected shadowing characteristic of the window pane.
51. The window pane of clause 43 wherein the substrate contributes to a preselected appearance of color of the window pane.
52. The window pane of clause 43 wherein the substrate contributes to a preselected shadowing characteristic of the window pane.
53. The window pane of clause 43 wherein the substrate comprises a plurality of layers, at least one of the layers having a different absorption spectrum than at least one other of the layers.
54. The window pane of clause 43 wherein at least a portion of at least one of the opposing and connecting surfaces comprises a mirrored surface.
55. The building element of clause 54 wherein the connecting surface comprises a plurality of connecting surfaces.
56. The building element of clause 55 wherein an unmirrored portion of the fluorescence collector is on one connecting surface and wherein the mirrored surface is present on at least one of the other connecting surfaces.
57. The building element of clause 55 wherein an unmirrored portion of the florescence collector is on at least one connecting surface and wherein the solar energy converter is mounted on the unmirrored portion of the at least one connecting surface.
58. The building element of clause 43 wherein the solar energy converter is mounted on one of the opposing surfaces of the fluorescence collector and further comprising an angled mirror for directing radiated light to the converter.
59. The building element of clause 58 wherein the angled mirror is situated on an angled connecting surface of the fluorescence collector.

## Claims

1. A building element (14) comprising:
a fluorescence collector (16) comprising
a substrate (10), and
particles (30) dispersed in the substrate to absorb light (12) from a plurality of directions and radiate the absorbed light, the particles comprising a dye, quantum dots, or combinations thereof,
the fluorescence collector having opposing surfaces (18, 20) and a connecting surface (24) between the opposing surfaces,
wherein the combination of the substrate and the particles is sufficiently transparent to permit light to reach the particles for absorption and to permit particles to radiate,
wherein at least two different portions of the fluorescence collector have different absorption spectrums; and
a solar energy converter (32) configured for receiving radiated light from the fluorescence collector of the building element.

2. The building element of claim 1 wherein the particles comprise at least two types of different particles (130, 230), with at least one type of particle having a different absorption spectrum than at least one other type of particle.

3. The building element of claim 1 wherein the particles or the substrate, or combinations thereof contribute to a preselected appearance of color of the building element, a preselected light absorption characteristic of the building element, a preselected shadowing characteristic of the building element, or combinations thereof.

4. The building element of claim 1 wherein the substrate is selected from the group consisting of polycarbonate, glass, polymethylmethacrylate, polystyrol, ceramics, and combinations thereof.

5. The building element of claim 1 wherein the substrate comprises a plurality of layers (112, 210, 310), at least one of the layers having a different absorption spectrum than at least one other of the layers.

6. The building element of claim 1 wherein at least a portion of at least one of the opposing and connecting surfaces comprises a mirrored surface (26), and wherein the connecting surface comprises a plurality of connecting surfaces (124, 224, 324, 424).

7. The building element of claim 6 wherein an unmirrored portion of the fluorescence collector is on one connecting surface (424) and wherein the mirrored surface is present on at least one of the other connecting surfaces.

8. The building element of claim 1 wherein the building element comprises a roof tile or a window pane and wherein the solar energy converter comprises a hidden converter.

9. A roof tile (14) comprising:
a fluorescence collector (16) comprising a substrate (10) and particles (30) dispersed therein to absorb light (12) from a plurality of directions and radiate the absorbed light, the fluorescence collector having opposing surfaces (18, 20) and a plurality of connecting surfaces (24) between the opposing surfaces wherein the particles comprise a dye, quantum dots, or combinations thereof;
a solar energy converter (32) configured for receiving radiated light from the fluorescence collector of the roof tile,
wherein at least a portion of at least one of the opposing and connecting surfaces comprises a mirrored surface (26),
wherein one of the opposing surfaces comprises a bottom opposing surface and wherein the bottom opposing surface comprises a mirrored surface.

10. The roof tile of claim 9 wherein the solar energy converter comprises a hidden converter.
